# EUROPEAN PATENT APPLICATION

(11) **EP 1 176 465 A2**
(43) Date of publication of application: **30.01.2002**
(21) Application number: 01480052.8
(22) Date of filing: 05.07.2001
(51) Int. Cl.: G03F 1/00, G03F 1/14

(54) **A ternary photomask and method of making the same**

(30) Priority: 25.07.2000 EP 00480070
(71) Applicant: International Business Corporation, Armonk, NY 10504 (US)
(72) Inventor: Coronel, Philippe, 28530 Barraux (FR); Rigaill, Denis, 91100 Corbeil Essonnes (FR); Richard, Olivier, 01170 Viry-Chatillon (FR)
(74) Representative: Klein, Daniel Jacques Henri

(57) **Abstract**

There is disclosed a ternary lithographic att-PSM (half tone) photomask that allows to simultaneously expose a photoresist-coated semiconductor wafer with three different levels of light intensity during the photolithography process. The improved photomask comprises a transparent plate having a patterned layer of a phase shift material (PSM) according to a first configuration formed thereon and a patterned layer of chromium according to a second configuration formed onto the patterned PSM layer. Each of said first and second configurations corresponds to a different masking level. Using this photomask, it is thus now possible to produce a photoresist layer having a corrugated surface in a single exposure pass of the semiconductor wafer during the photolithography process instead of using two photomasks and two exposure steps as usual.

## Description

### FIELD OF INVENTION

The present invention relates to the manufacture of semiconductor integrated circuits (ICs) and more particularly to a ternary lithographic photomask that allows to simultaneously expose a photoresist-coated semiconductor wafer with three different levels of light intensity during the photolithography process. The photomask is basically of the attenuated phase shift type but it is further provided with an adequate pattern of chromium, in addition to the conventional phase shift material pattern. The combination of both patterns in a single photomask allows to produce a corrugated surface in the photoresist layer in a single exposure pass of the semiconductor wafer during the photolithography process instead of using two photomasks and two exposure steps as usual. The present invention also encompasses the method of fabricating such a multi-intensity lithographic photomask.

### BACKGROUND OF THE INVENTION

In essence, in the manufacture of semiconductor integrated circuits, the photolithography process comprises the basic steps of: depositing a photoresist layer onto the silicon wafer, exposing the photoresist layer to UV light through a mask and then developing it to leave a patterned photoresist layer having the desired configuration. Let us see these processing steps in more details. First, a silicon wafer is coated with a photoresist material. Usually, there is provided an underlying layer of an anti-reflecting coating (BARC) material. Pre and post-deposition bakes of these materials are performed as standard if so needed. The photoresist-coated wafer is exposed to a monochromatic UV light source in a lithography exposure tool through a photomask. This photomask includes a specific configuration in its effective zone to be reproduced on the wafer at the exposure step. This configuration corresponds to the layout of a determined masking level in the wafer fabrication. A latent image is formed in the photoresist layer. After exposure, the photoresist layer is baked and developed as standard. There is produced a patterned photoresist layer on the wafer surface having said desired configuration at a reduced scale. The wafer is now ready for a processing operation (ion implantation, etching, ...).

The photoresist can be either of the negative or positive type. If a positive photoresist is used, the regions of the photoresist layer that have been exposed to light during the exposure step will be removed after development. On the contrary, if a negative photoresist is used instead, the regions that have received the light radiation during the exposure step will remain after development.

There are different methods to fabricate the conventional photomasks used to date in the photolithography process to produce such patterned photoresist layers. Some will be now briefly described hereinbelow.

In essence, conventional photomasks can be classified in three broad families: chromium on glass masks, attenuated phase shift masks (or halftone masks) and alternated phase shift masks (or Levenson masks). In all cases, a binary photomask consists of a transparent substrate generally made of a quartz (or ultra-pure glass) plate with a substantially opaque (or partially opaque) pattern to UV light formed thereon at desired locations. As used herein, "substantially opaque" means a material through which less than 0.1% of the optical radiation can pass. Chromium is especially preferred due to its wide use in the semiconductor mask-making industry.

The chromium-on-glass (COG) mask is first produced by the deposition (e.g. using a sputtering or vapor phase deposition technique) of a bottom layer of a chromium-based material (the real composition of which much depends upon the mask supplier fabrication process) onto the quartz plate surface. Then, the plate is coated with a top film of a photoresist material. The resulting part, i.e. the quartz plate coated with the dual chromium/photoresist layer, is called a "blank". The blank is then exposed according to the adequate configuration to subsequently produce the desired pattern on the photoresist layer coating the silicon wafer. The exposition is made using either a laser beam or an electron beam equipment. After exposure, the blank is etched using the patterned photoresist layer as an in-situ mask to reproduce the desired pattern in the chromium layer using either a wet or a dry etch process. Next, the remaining photoresist material is removed by ashing or wet etching as standard. Finally, a pellicle is drawn over the structure for protection purposes to produce the completed COG mask. Note that the above described mask fabrication process also includes several cleaning and inspection steps, not detailed here for the sake of simplicity, to prevent defect occurrence on the COG mask surface.

The attenuated phase shift mask, also referred to as att-PSM mask, aims to improve the resolution of the COG mask, but it fabrication requires a more complex process than COG masks. To that end, materials other than chromium have been used on the blanks. In the present case of an att-PSM mask, the substrate is still a quartz plate. First, a layer of a phase shift material is deposited on the quartz plate. Then, a layer of a chromium-based material is deposited onto the structure followed by the deposition of a photoresist layer. The resulting part is still called a "blank". All these fabrication steps are performed in the mask house of the blank suppliers such as HOYA Corp., Tokyo, Japan or TOPPAN PRINTING Co, Tokyo, Japan. Semiconductor manufacturers generally purchase only the att-PSM blanks and personalize them to meet their specific design needs. Now, as for COG masks, the att-PSM blank is exposed according to the said adequate configuration and then developed. After development, a first etching is performed which removes the chromium at desired locations leaving a patterned chromium layer to be subsequently used as an in-situ hard mask. The structure is then cleaned and the phase shift material exposed through the chromium hard mask is now etched. This etching step transfers said configuration in the phase shift material. Next, a second photoresist layer is deposited onto the structure, then exposed and developed as standard to produce a patterned photoresist layer. Chromium is totally etched away, e.g. by wet etching using an adequate chemistry, except at the border of the part to leave a chromium frame all around the patterned PSM layer. At this stage of the fabrication process, the remaining photoresist is removed by ashing or by wet cleaning as standard. The chromium frame includes all the necessary secondary patterns (bar-codes, alignment marks, ... ) that will be subsequently necessary to the photolithography exposure system. The chromium frame which is formed at the periphery of the att-PSM mask delineates the pattern to be reproduced or printed on the photoresist coated silicon wafer. Finally, as for COG masks, a protective pellicle is tightly drawn over the mask. Again, cleaning and inspection steps have not been included in this description for the sake of simplicity but are still present in the att-PSM mask fabrication process.

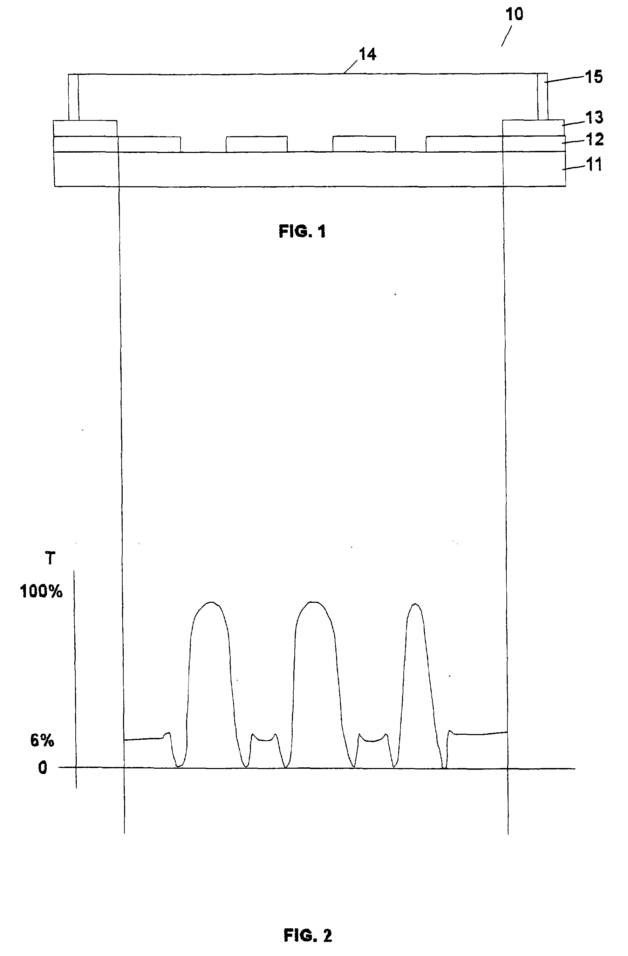

FIG. 1 schematically shows the structure of an att-PSM mask obtained with such a fabrication process. Att-PSM mask 10 is comprised of a quartz plate 11 having a patterned PSM layer 12 formed thereon (it is important to point out that the illustrations are not necessarily drawn to scale). The chromium frame formed at the mask 10 periphery referenced 13 delineates the operative surface of the patterned PSM layer 12, i.e. the configuration to be reproduced on the photoresist-coated silicon wafer. The protection pellicle 14 is tightly drawn over the mask 10 and affixed on the aluminum ring 15.

FIG. 2 shows the typical transmission function of the light intensity that is obtained on the photoresist-coated silicon wafer when it is illuminated through the att-PSM mask 10 of FIG. 1, assuming that an oxide or an oxynitride of MoSi is used as the PSM material as standard (these compounds have a transmissivity of about 6% for a DUV 248 nm wavelength radiation). The curve shown in FIG. 2 illustrates the quasi-binary structure of att-PSM mask 10 because the transmission function can only take two typical values: 6% and 100% (if we except some residual troughs at 0%). Light transmission function refers to the intensity of light that crosses the mask to illuminate the photoresist-coated silicon wafer compared to the intensity that impiges the mask, i.e. the ratio of the intensity of the transmitted light passing through the mask to the intensity of the incident light.

As mentioned above, phase shift materials usually have a transmission factor that is usually around 6% for the working wavelength that is used during the exposition step of the photolithography process (this transmission function can anyway range from lower to higher values in some extent). It induces a 180° shift in the phase when compared to the light that only passes through the quartz plate. However, in the past decade, phase shift materials having a higher transmission function (typically above 15%) were employed. In this case, the remaining light intensity between two patterns can exceed the photoresist sensitivity on the wafer. As a consequence, parasitic patterns (referred to as "side lobes" in the technical literature) are then likely to appear in the patterned photoresist layer coating the silicon wafer after exposure and development causing significant losses in wafer manufacturing yields. To correct this defect when it appeared, some chromium material was left between certain openings in the patterned PSM layer during att-PSM mask fabrication. However, this technique was very seldom used because it required very accurate mask alignments and tightly controlled etching processes, which in turn, created major manufacturing problems, such as a significant reduction of the mask manufacturing yield. As a final result, this technique was rapidly abandoned and is no longer used to date.

Finally, alternated phase shift masks, also referred to as alt-PSM masks, are capable to increase even more the resolution achieved with att-PSM masks. Their principle is as follows: using selective etched areas around the lines of the chromium pattern, it is possible to tune the phase of light on each side of the lines. If the phase difference is 180 degrees, the highest possible resolution is then achieved.

In all cases, there is produced a photomask provided with a binary pattern, presence or absence of the masking material coating the quartz plate of the photomask after etching. These photomasks will be referred to as binary photomasks hereinbelow. Note that, the step height of the masking material is the same across the whole photomask surface.

Let's consider the case of a wafer coated with a photoresist layer (it is possible to have a BARC film under the photoresist layer or not). The resulting structure is called the photoresist stack or stack in short. For the exposure step, this stack can be characterized, among other parameters, by two values that are (1) the dose to print (DTP) and (2) the dose to clear (DTC). The dose to print is the minimum amount of energy (in mJ/cm²) that is needed to start printing a latent image in the stack. The dose to clear is the minimum amount of energy (in mJ/cm²) that is needed to develop said latent image across the whole stack thickness. Thus, for a given stack and given DTC and DTP values, any exposure that will have an energy between DTP and DTC values will lead to a partial development of the photoresist material. Exposure of the stack can be performed with any binary photomask (i.e. either a COG, an att-PSM or an alt-PSM mask).

In semiconductor wafer processing, it is sometimes desired to produce the patterned photoresist stack coating the silicon wafer with a corrugated surface. So far, this result can be achieved only with two exposure steps of the stack and using two different masks.

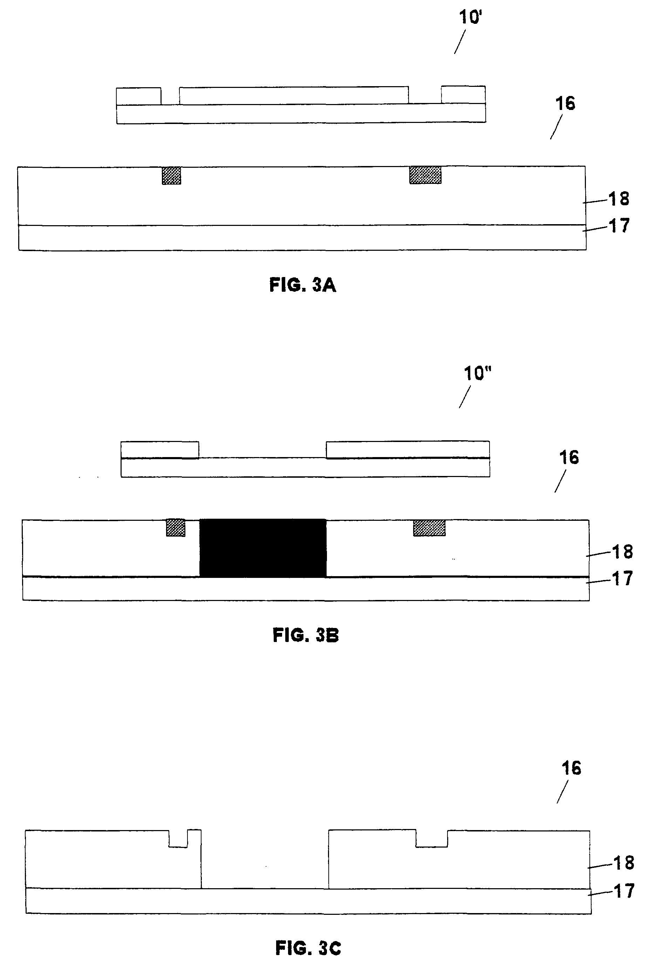

A conventional way to produce a corrugated patterned photoresist stack will be now described by reference to FIGS. 3A-3C. Now turning to FIG. 3A, there is schematically shown a semiconductor structure 16 comprised of a silicon substrate 17 having a photoresist stack 18 formed thereon. The stack 18 is exposed to UV light through att-PSM mask 10' having a first configuration. This first exposure is such as the amount of energy illuminating the stack is between the dose to print and the dose to clear for the photoresist material to produce a partial exposure thereof. FIG. 3A depicts the stack after exposure wherein the exposed portions are shown in gray. Now, the resulting semiconductor structure 16 is submitted to a second exposure as illustrated in FIG. 3B, using a second binary mask, such as att-PSM mask 10", having a second configuration. Masks 10' and 10" are partial representation of larger att-PSM masks having the same construction as att-PSM mask 10. For the second exposure, it is possible to use a dose that is higher than the dose to clear, so that the whole thickness of the stack 18 is exposed by the UV light for total exposure. At the stage of FIG. 3B, the portions in the stack 18 that have been totally exposed are shown in black. The stack 18 is then developed as standard. As apparent in FIG. 3C, after development, the semiconductor structure 16 is provided with a patterned stack 18 having a corrugated surface. Note that the order of the two exposure steps is irrelevant.

The above described process implies the need to have two different masks and require to perform two exposure steps to transfer two masking levels (layout). Moreover, it also induces process variations: the overlay between the two exposures is not constant, it varies and thus can affect the wafer manufacturing yield. It also dramatically impacts the turn-around-time (TAT) for the whole photolithography process.

Still another way to create a corrugated patterned photoresist stack consists to superpose two layers of photosensitive materials having a different sensitivity, i.e. having different DTP and DTC values. The first deposited photoresist must have a higher DTC than the second deposited photoresist. BARC material can be used or not as usual. This technique still requires two exposure steps and two masks as in the method described above in connection with FIGS. 3A-3C, but at the cost of using two different photoresist materials instead of one. However, in substance, the drawbacks are substantially the same.

So far, it is thus not possible to create a corrugated pattern in the photoresist stack coating a silicon wafer with a simple and affordable photolithography process. The state-of-the-art methods described above require two exposure steps and two masks. Therefore, it would be highly desirable to define a new photolithography process that would be capable to produce such a corrugated patterned photoresist stack with only one mask and one exposure step. Process integration would be greatly improved, significantly reducing thereby the number of processing steps, and in turn, would save time and cost. In addition, it would also be a major improvement to create said corrugated patterned photoresist stack without any significant changes in the current state-of-the-art photolithography process in the course of the silicon wafer fabrication.

### SUMMARY OF THE INVENTION

It is therefore a primary object of the present invention to improve the photolithography process in providing a ternary lithographic photomask adapted to transmit light with three levels of intensity.

It is still another object of the present invention to provide a method of fabricating a ternary lithographic photomask adapted to transmit light with three levels of intensity which does not require any significant change in the process of fabricating conventional att-PSM photomasks.

It is another object of the present invention to provide a ternary lithographic photomask adapted to transmit light with three levels of intensity to produce a corrugated surface on a patterned photoresist stack in a photoresist-coated silicon wafer during the photolithography process.

These desirable results and other objects of the present invention are realized by the ternary lithographic photomask of the present invention which comprises: a transparent plate having a patterned layer of a phase shift material (PSM) according to the configuration of a first masking level formed thereon and a patterned layer of an opaque material, such as chromium, according to the configuration of a second masking level formed onto the patterned PSM layer. As a result, areas having high light transmission, areas having intermediate light transmission and areas having low light transmission are defined in said photomask.

The present invention also encompasses the method of fabricating such a ternary lithographic photomask which comprises the steps of :
a) providing a att-PSM blank comprising: a plate having a high light tramsmissivity, a bottom layer of a phase shift material (PSM) having an intermediate light transmissivity, a layer of an opaque material such as chromium having a low light transmissivity and a top layer of a photoresist;
b) patterning said top photoresist layer in a lithography step according to the configuration of a first masking level;
c) transferring said first configuration in the chromium layer in an etching step;
d) transferring said first configuration in the PSM layer using the patterned chromium layer as an in-situ mask in an etching step;
e) removing the remaining photoresist material;
f) depositing a layer of a photoresist material onto the resulting structure;
g) patterning said layer of photoresist material in a lithography step according to the configuration of a second masking level;
h) transferring said second configuration in the underlying chromium layer in an etching step; and,
i) removing the remaining photoresist material;
wherein the portions of the plate that are not coated by any material form said areas of high light transmission, the portions of the plate that are only coated by the phase shift material form areas of intermediate light transmission and the portions of the plate that are coated by said chromium material form areas of low light transmission resulting thereby in a ternary photomask.

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings.

### BRIEF DESCRIPTION OF THE DRAWINGS

FIG. 1 schematically shows the cross-section of a conventional att-PSM photomask.

FIG. 2 shows the transmission function of the FIG. 1 photomask when an UV light radiation impinges a photoresist-coated silicon wafer.

FIGS. 3A-3C show the production of a patterned photoresist stack having a corrugated surface on a silicon wafer according to a conventional technique of the prior art which requires two exposure steps and two masks.

FIGS. 4A-4H illustrate the fabrication of a ternary photomask according to the present invention adapted to transmit light with three intensity levels.

FIG. 5 shows the transmission function of the FIG. 4H photomask when an UV light radiation impinges a photoresist-coated silicon wafer.

FIG. 6 shows the patterned photoresist stack having a corrugated surface on a silicon wafer that is produced with only one exposure step when the ternary photomask of FIG. 4H is used.

### DESCRIPTION OF A PREFERRED EMBODIMENT

According to the present invention there is described a ternary photomask adapted to transmit three different levels of light intensity instead of two as it is the case with the "binary" photomasks described above in the BACKGROUND OF THE INVENTION section. This ternary photomask includes areas with no light transmission, areas with a maximum of light transmission and areas with an intermediate light transmission. As used herein a high transmissivity material is one that transmits 50% or more of the incident light and a low transmissivity material is one that transmits 35% or less of the incident light. The transmissivity strongly depends of the working wavelength.

### Ternary photomask fabrication

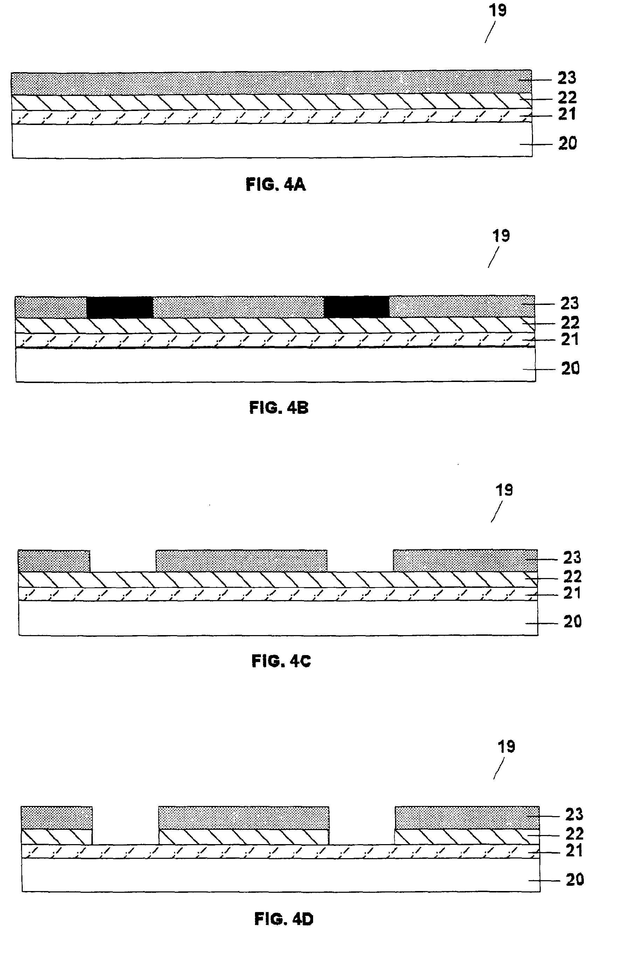

A ternary mask is fabricated using the following method. A 6x6 inches DUV att-PSM blank bearing reference EHQ60252SK52A-AR3 supplied by Hoya Corp., Tokyo, Japan, can be used as the starting material. The att-PSM blank referenced 19 in FIG. 4A, represents the photomask at the initial stage of the fabrication process. Now turning to FIG. 4A, the blank consists of a 250 mils thick quartz plate 20 coated with a bottom 80 nm MoSi layer 21 (adapted to the 248 nm wavelength light radiation), a 100 nm thick layer 22 of chromium and a 300 nm thick ZEP 7000 top photoresist layer 23 (supplied by NIPPON ZEON Co. Ltd., Tokyo, Japan).

A first configuration is printed in the top photoresist layer 23 utilizing a MEBES 4500D electron beam writing tool (commercialized by ETEC Systems Inc., Hayward, CA, USA). This configuration is represented by a specific set of mask design data stored in the memory of the writing tool and corresponds to a first masking level. After exposure, the blank is shown in FIG. 4B. Then, the photoresist layer 23 is developed in an ASE 500 wet etch tool (from STEAG Hamatech, Sternenfels, Germany) to produce a masking layer as shown in FIG. 4C. Next, the chromium of layer 22 exposed through the patterned photoresist layer 23 is etched as standard, for instance, using an APT 3110, a tool supplied by FAIRCHILD CONVAC, Fremont, CA, USA. At this stage of the mask fabrication process, the blank is shown in FIG. 4D. The remaining photoresist material of layer 23 is removed by wet etching in a ASC 500 tool (from STEAG Hamatech, Sternenfels, Germany) using a Piranha solution at 90 °C as standard.

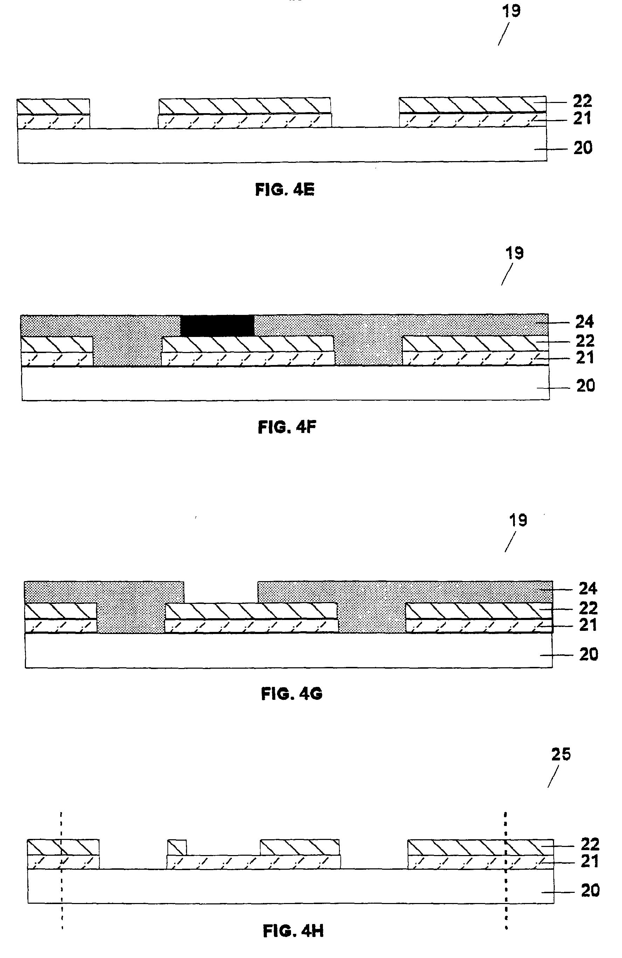

After chromium etch has been completed, using the remaining chromium layer 22 as an in-situ hard mask, the phase shift material is etched by dry etching in a NEXTRAL 330 RIE reactor, a tool sold by NEXTRAL, Grenoble, France, using a CF4/O2 chemistry as standard. The blank 19 is shown in FIG. 4E.

Next, a new photoresist layer 24, for instance the IP3600 (TOKYO OHKA KOGYO Co. Ltd., Kanagawa, Japan) is deposited onto the photomask using a RC8 tool spin coater (from Karl SUSS, Munich, Germany) and exposed as standard (FIG. 4F). The second exposure pass consists in writing a second configuration corresponding to another masking level. This second writing operation is performed with an ALTA 3700 exposure tool (from ETEC Systems). The photoresist material of layer 24 is developed using the APT 3110 tool mentioned above to leave a patterned photoresist layer (FIG. 4G).

Finally, using said patterned photoresist layer 24 as a masking layer, the chromium of layer 22 is etched as described above using the APT 3110 tool. Finally, the remaining photoresist of layer 24 is removed as described above in the ASC 500 tool. At the final stage of the fabrication process, the ternary att-PSM photomask of the present invention is shown in FIG. 4H where it bears numeral 25 (the protection pellicle has not been represented). Note that, for simplification reasons, the cleaning and inspection steps have not been described herein.

A remarkable aspect of the present invention is that all the processing steps (photoresist deposition and development, chromium etch, ... ) described above are standard and all the tools cited above are commercial products. The ternary att-PSM photomask of the present invention can be distinguished from conventional att-PSM masks only by the fact that there is now a desired pattern in the chromium layer (in addition to the chromium frame). The first configuration (which corresponds to a first masking level) is reproduced by the patterned PSM layer 21 while the second configuration (which corresponds to a second masking level) is reproduced by the patterned chromium layer 22. According to the present invention, there is a sort of concatenation of the two sets of mask design data that are printed in a single photomask instead of being separately printed in two different photomasks.

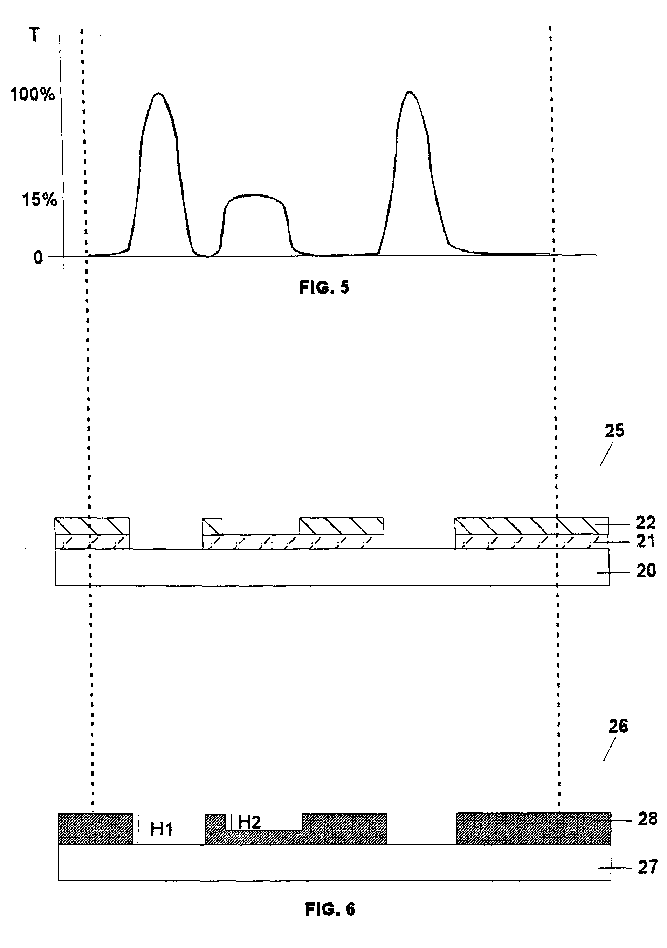

FIG. 5 shows the typical transmission function of the light intensity that is obtained on the photoresist-coated silicon wafer when it is illuminated through ternary att-PSM photomask 25 of FIG. 4H. The curve shown in FIG. 5 clearly demonstrates its ternary structure because the transmission function can now take three values (0%, 6%, and 100%) if the photomask 25 is used with a 248 nm wavelength radiation. However, the difference between these three values can be insufficient to reach the adequate contrast during the exposure step. In this instance, it is recommended to expose the silicon-coated wafer with a 365 nm wavelength light radiation, so that, the three above values respectively become 0%, 15% and 100%, which are much more favorable in that respect.

### Exposure of the photoresist-coated silicon wafer

The use of the ternary photomask 25 of FIG. 4H and advantages attached thereto will be now described by reference to FIG. 6. For this experiment, a standard 200 mm diameter silicon wafer is used. It is first coated with a layer of the TOK3250 photoresist (supplied by Tokyo Ohka Kogyo Co. Ltd., Kanagawa, Japan) using the TEL ACT8 photoresist coater (a tool manufactured by TOKYO ELECTRON Ltd, Tokyo, Japan). FIG. 6 schematically shows the structure referenced 26 comprising a substrate 27 coated with a photoresist stack 28 (use of an underlying layer of a BARC material is optional as usual). The photoresist stack 28 is baked using appropriate thermal treatments as standard, then exposed using the photomask 25. Exposure takes place in a Nikon NSR 2205i-12-D, a step and repeat system (sold by Nikon Corp., Tokyo, Japan) which is tuned on the 365 nm wavelength mentioned above for better results.

The exposed wafer is baked and developed using a TEL ACT8 tool (TOKYO ELECTRON Ltd, Tokyo, Japan) using standard operating conditions. As apparent in FIG. 6, the stack 28 has a corrugated surface and presents steps having two different heights H1 and H2. Stack 28 is quite identical to stack 18 of FIG. 3C in that respect but it is to be noted that this result has been obtained with only one photomask and one exposure step.

Concluding above described experiments, wafer characterization were conducted with a Dektak atomic force microscope (AFM), an equipment sold by VEECO Instruments Inc., Plainview, NY, USA. The measurements showed that the single exposure performed with ternary photomask 25 of the present invention really produced the desired corrugated surface in the patterned photoresist stack schematically shown in FIG. 6.

More generally, let us consider that a positive photoresist coats the silicon wafer to be exposed through such a ternary att-PSM photomask 25. In this case, the areas of photomask 25 with high light transmission are designed to enable the photoresist to be fully removed after the development step, the areas with low light transmission are designed to enable as few photoresist as possible to be removed, and finally, the areas with intermediate light transmission are designed to enable a given amount of photoresist, but not all, to be removed. This can be achieved using a PSM layer with an intermediate light transmissivity in the 15%-25% range for the working wavelength. The light that passes through layer 21 has enough energy to start printing a latent image on the photoresist stack, but this energy is not sufficient enough to print this latent image through its whole thickness.

By tuning the process parameters (nature of the photoresist and its thickness, BARC or no BARC, thermal treatments for bake steps, exposure, development and etching operating conditions ... ) it is possible to control the ratio of step heights (H1/H2) and the slope of said steps.

Likewise, mask parameters (materials forming the partially transmitting layer, mask processing steps, ... ) can also be tuned as well.

A ternary photomask can be fabricated using variants of the above described method based upon the use of phase shift materials that enable light dephasing and light attenuation, i.e. that affect light intensity transmission across the photomask. These methods can even be generalized to the fabrication of multi-intensity masks capable to transmit more than three light intensity levels. Such multi-intensity photomasks would be based upon the use of at least two phase shift materials having different light transmission functions to implement a corresponding number of intermediate values.

While the invention has been particularly described with respect to a preferred embodiment thereof it should be understood by one skilled in the art that the foregoing and other changes in form and details may be made therein without departing from the spirit and scope of the invention.

## Claims

1. A method of forming a ternary lithographic att-PSM photomask having high light transmission areas, intermediate light transmission areas and low light transmission areas comprising the steps of:
a) providing a att-PSM blank comprising: a plate having a high light tramsmissivity, a bottom layer of a phase shift material (PSM) having an intermediate light transmissivity, a layer of an opaque material such as chromium, having a low light transmissivity and a top layer of a photoresist;
b) patterning said top photoresist layer in a lithography step according to the configuration of a first masking level;
c) transferring said first configuration in the chromium layer in an etching step;
d) transferring said first configuration in the PSM layer using the patterned chromium layer as an in-situ hard mask in an etching step;
e) removing the remaining photoresist material;
f) depositing a layer of a photoresist material onto the resulting structure;
g) patterning said layer of photoresist material in a lithography step according to the configuration of a second masking level;
h) transferring said second configuration in the underlying chromium layer in an etching step; and,
i) removing the remaining photoresist material;
wherein the portions of the plate that are not coated by any material form said areas of high light transmission, the portions of the plate that are only coated by the phase shift material form areas of intermediate light transmission and the portions of the plate that are coated by said chromium material form areas of low light transmission resulting thereby in a ternary mask.

2. A ternary lithographic att-PSM photomask comprising a transparent plate having a patterned layer of a phase shift material (PSM) according to the configuration of a first masking level formed thereon and a patterned layer of an opaque material such as chromium according to the configuration of a second masking level formed onto the patterned PSM layer, defining thereby areas having high light transmission, areas having intermediate light transmission and areas having low light transmission in said photomask.
